# EUROPEAN PATENT SPECIFICATION

(11) **EP 3 366 369 B1**
(45) Date of publication and mention of the grant of the patent: **01.04.2020**
(21) Application number: 17158427.9
(22) Date of filing: 28.02.2017
(51) Int. Cl.: B01F 11/00, B01F 15/00, B25J 9/16, B25J 15/02

(54) **CLAMPING MECHANISM, FLUID MIXER COMPRISING SUCH A CLAMPING MECHANISM AND METHOD FOR CALIBRATING A CLAMPING MECHANISM**
KLEMMMECHANISMUS, FLUID MISCHER ENTHALTEND SOLCHES KLEMMMECHANISMUS UND VERFAHREN ZUM KALIBRIEREN EIN KLEMMMECHANISMUS
MÉCANISME DE SERRAGE, MÉLANGEUR DE FLUIDES COMPRENANT LEDIT MÉCANISME DE SERRAGE ET PROCÉDÉ POUR CALIBRER UN MÉCANISME DE SERRAGE

(43) Date of publication of application: 29.08.2018
(73) Proprietor: Fast & Fluid Management B.V., 2171 KZ Sassenheim (NL)
(72) Inventor: POST, Johannes Hermanus Nicolaas, 2171 NM Sassenheim (NL); KROM, Ronald Peter, 2225 HC Katwijk (NL)
(74) Representative: De Vries & Metman

(56) References cited:
- WO-A1-2007/103963
- WO-A1-2007/103980
- WO-A2-03/028873

## Description

Clamping mechanism, fluid mixer comprising such a clamping mechanism and method for calibrating a clamping mechanism.

### TECHNICAL FIELD

The present disclosure relates to a mechanism for clamping a container, the clamping mechanism comprising a support structure on which a first clamping member and an opposing second clamping member defining an adjustable clamping distance therebetween are mounted, at least one of the first and second clamping member being controllably moveable to increase or decrease the clamping distance by an electrical actuator means, which electrical actuator means is controllable by a control means. The invention also pertains to a fluid mixer, in particular to a mixer for paints, colourants and the like, comprising such a clamping mechanism and to a method for calibrating a clamping mechanism.

### BACKGROUND ART

A device of this kind is described in WO 03/028873. The prior art device for clamping a container in a mixer for fluids, comprises a clamping unit selectively operable for clamping a container by the application of compressive forces. These compressive forces are applied to the container by a clamping member which is connected to a moveable member via resilient compression members, in particular helical springs. The mixer subsequently mixes the contents of the container. Although the springs in between the moveable members and the clamping members may compensate for relatively small displacement errors of the moveable members, these springs also introduce an undesired degree of freedom to the container clamped in between the clamping members. In particular when such a container is filled with a fluid and closed by a separate lid, a mixing operation may introduce substantial forces imposed on the lid by the fluid and may even force the lid off the container against the spring force of the resilient compression members and potentially spilling the fluid, thereby substantially contaminating the fluid mixer.

Further US Patent 5,268,620 describes a system for controlling the clamping force in fluid mixers, by measuring the current absorbed by the electric motor driving the clamping members in between which a fluid container may be clamped. This provides an estimation of the clamping force imposed on the container as the current absorbed by the electric motor increases when the clamping members start clamping the container, thereby signalling the start of the clamping state. However, some factors may influence the current absorbed by the electric motor over time, such as pollution of the drive means, such as drive screws, or dirt on the clamping members. These factors may cause false indications of a clamping state and result in the premature halting of the decrease of the distance between the clamping members, causing a suboptimal grip of the clamping members on the container.

Document WO-A-2007/103963 discloses a device in accordance with the preamble of claim 1.

### SUMMARY

According to the present invention, a clamping mechanism is provided according to claim 1. Such clamping mechanism may for example be advantageously applied in a fluid mixer in which a fluid container is placed for batch-wise mixing by means of e.g. a vibrating motion. The support structure may be formed e.g. as an integral frame or may comprise a plurality of connected sub-frames. In particular in vibrating applications, such as fluid mixers, it may be advantageous to have a first support structure to support or mount the device on a floor or other support surface, and have at least a second frame on which the clamping members are mounted. Such a second frame maybe mounted in said first frame by means of a spring and/or damper structure.

The first and second clamping member are mounted on the support structure defining an adjustable clamping distance therebetween. The first and second clamping member maybe mounted on a shared mounting structure, such as one or more rods, or may be mounted on the support structure via individual mounting elements. The clamping distance is the distance spanned between the first and opposing second clamping member. The clamping distance is the distance or volume spanned between the first and second clamping members intended to receive an object. However, it is noted that the clamping distance is also defined as the distance between the first and second clamping member in case no object is clamped in between the clamping members. The clamping distance is the volume spanned between the first and second clamping member and may e.g. be visualized by the space bounded by the first and second clamping member on the one hand and the imaginary planes extending from each edge of the first clamping member towards the respective associated edge of the opposite second clamping member.

To adjust the clamping distance at least one of the first and second clamping members are configured to be controllably moveable with respect to each other in order to increase or decrease said clamping distance. This relative movement may be implemented as a linear movement, or any other suitable movement with a component of movement in a direction towards the other clamping member. One of the clamping members may be mounted fixedly to the support structure, while the other clamping member is moveably mounted, or both the first and second clamping member may be moveably mounted to the support structure. The first and/or second clamping member are actuated by electrical actuator means which are controlled by control means. The control means maybe integral part of the actuator means or implemented separately from the actuator means. The actuator means may be implemented as an integral unit or distributed over multiple sub-units throughout the device.

In an open state in which the first and second clamping members are positioned away from each other, the clamping distance may receive an object in between the first and second clamping member, e.g. by placing the object to be clamped on either the first or second clamping member. By actuating the actuator means such that the clamping distance is decreased, i.e. moving the first and/or second clamping member towards the other, eventually both the first and the second clamping member will touch the object and the clamping mechanism will thereby reach its clamping state. This moment is observable by measuring an electrical characteristic of the electrical actuator means, such as the (change in the) amount of electrical current to and/or voltage over the actuator means. The change in or the amplitude of the electrical characteristic may be used as a measure for the clamping force applied to the object clamped in between the first and second clamping member. In many applications of clamping mechanisms it is important to apply the right amount of clamping force or pressure on the object; too little and the object may escape the clamping members, too much and the object may be damaged or even (partially) disintegrate. The relationship between the electrical characteristic and the clamping force is usually determined during the production of such mechanism. However, many factors, such as pollution of the actuator means or mounting structure may influence this relationship over its lifespan, which may result in clamping errors of varying severity. Pollution of the actuator may increase electrical characteristic of the actuator means because e.g. friction between the clamping means and the actuator means increase, or pollution such as grease, or e.g. run-in of the system over time, may result in a decrease of the electrical characteristic of the actuator means. By providing resilient compression means having a known compression versus force ratio, positioned outside of the clamping distance, which are compressible either directly or indirectly by at least one of the first and second clamping member, while measuring the electrical characteristic, the relationship between the electrical characteristic and the resulting actual force may be recalibrated in a production environment during the lifetime of the device. Such recalibration may include comparing the measurement of the electrical characteristic with a predetermined value to calibrate at least a clamping force as a function of the electrical characteristic of the electrical actuator means.

The resilient compression means may be located above or under the clamping members, but may also be located beside the volume of the clamping distance, i.e. outside the volume spanned between the first and second clamping member. The latter may e.g. be advantageously provided by compression means adjacent to, or even around guide means or actuator means of the clamping members.

In an embodiment of the clamping mechanism according to the invention, at least two resilient compression means are mounted outside the clamping distance. Two or more resilient compression means, such as e.g. mechanical (helical), (hydro-)pneumatic or hydraulic springs, may be positioned at a distance from each other, preferably substantially symmetric, such that the clamping member(s) are able to compress the resilient compression means during a (re)calibration of the relationship between the electrical characteristic and force resulting from the compression of the resilient compression means.

In an embodiment of the clamping mechanism according to the invention, the resilient compression means is mounted such that an electrical circuit is switched upon initial touch of at least one of the first and second clamping member with the resilient compression means. During a (re)calibration of the relationship between the electrical characteristic and force resulting from the compression of the resilient compression means it is relevant to determine whether a change in the electrical characteristic of the electrical actuator means is due to the (start of) compressing the resilient compression means. Therefore an electrical circuit is switched upon initial touch of at least one of the first and second clamping members. This may be a separate sensor, such as e.g. a proximity sensor, touch sensor or any other suitable sensor, or may be implemented as an integral part of the resilient compression means and/or the moveable clamping member(s). The latter can e.g. be implemented by means of an electrical conducting resilient compression member such as a metal helical spring, and a conducting touch surface of the clamping member, which, in case the clamping member touch the compression member close an electrical circuit which can be detected by or at least communicated to the control means in order to signal the start of the compression. In an alternative embodiment the start of the compression of the resilient compression means is indicated by positional information of the clamping members stored in a memory. In an embodiment of the clamping mechanism according to the invention, the resilient compression means are configured such that the resulting force of the resilient compression means is substantially proportional with the compression thereof. Since the (re)calibration procedure is inter alia intended for determining the relationship between the electrical characteristic and the force imposed via the actuator means by the clamping members, it may be advantageous to provide compression means which are substantially proportional with the compression thereof. However the relationship between the electrical characteristic and the force imposed via the actuator means by the clamping members may also be a non-linear relationship, e.g. by implementing a non-linear spring or multiple cooperating springs and e.g. detecting the force transition point. By measuring the electrical characteristic while compressing the resilient compression means and determining the resulting force of such compression, the estimation of the relationship between the electrical characteristic and the force imposed by the clamping member can be improved.

In an embodiment of the clamping mechanism according to the invention, the control means is configured to impose a predetermined clamping force to a container disposed between the first and second clamping member. The clamping mechanism may be advantageously applied to clamp a container, e.g. a container comprising fluids to be homogenized. Several types of containers may require a different clamping pressure in order to apply the minimal required clamping force to hold the container during an operation, while not exceeding the maximum pressure which could damage or even disintegrate the container. The maximum amount of pressure allowed may depend e.g. on the material, quality and dimensions of the container, whereas the minimum pressure required may depend on the weight of the contents and/or empty container and the operation applied to the clamped container.

In a further embodiment of the clamping mechanism according to the invention, the imposed clamping force is in operation estimated based on at least an electrical characteristic of the electrical actuator means during a change of the clamping distance. By driving the actuator means and measuring an electrical characteristic, such as e.g. voltage or electrical current to the actuator means, the control means are able to distinguish the state wherein the clamping means are moving towards each other, or at least changing the clamping distance, and the situation wherein both the first and second clamping members touch the object to be clamped. By further actuating the actuator means the electrical characteristic will typically change, e.g. an increase in voltage and/or current to the actuator means, depending on the type of actuator means. The amount of such electrical characteristic will be a representation for the amount of force applied. The same applies for the calibration situation, wherein at least one of the first and second clamping members compress the compression means.

In an embodiment of the clamping mechanism according to the invention, it further comprises detection means for detecting the presence of an object disposed between the first and second clamping member. Detection means may e.g. comprise an optical, inductive, capacitive or magnetic type sensor to determine the presence (or absence) of an object between the first and second clamping member. The information of this detection means may be used e.g. to initialize the clamping operation, or any other subsequent operation, or may be used to determine that the mechanism is empty such that a calibration operation may be initialized.

In an embodiment of the clamping mechanism according to the invention, the control means comprise a calibration mode, wherein, in operation, at least one of the first and second clamping member are controlled to the move towards the resilient compression means, such that the resilient compression means are at least partially compressed, while measuring an electrical characteristic of the electrical actuator means and determining at least one of the clamping distance and the amount of compression of the resilient compression means. By subsequently comparing the data with earlier estimations it can be determined whether or not to modify the estimation of the relationship between the electrical characteristic and the imposed force. By doing this operation in a separate calibration mode, it may e.g. be further required and monitored that the clamping mechanism is empty before calibration. Such initialization of a calibration mode may be done e.g. at a predetermined time interval, after a specified number of operations, or at specific events, such as start-up, shutdown or at detection or recovery of an error.

In an embodiment of the clamping mechanism according to the invention, the first and second clamping member are substantially planar. A substantially planar or at least partially planar configuration provides support for many types of applications, in particular e.g. fluid containers such as paint cans or other containers comprising fluids, as these containers are typically modelled to remain stable on a planar support.

In an embodiment of the clamping mechanism according to the invention, the electrical characteristic of the electrical actuator means comprises electrical current and/or electrical voltage. Depending of the type of actuation and the (power) control thereof, an increase in the load may result in an increase of voltage and/or current to the actuator means. In general, in case the load on the clamping members changes, the electrical characteristic such as voltage and/or current to the actuator means may show a change. The amount of change and/or the magnitude of this electrical characteristic may provide an indication of the load imposed by the clamping members.

In an embodiment of the clamping mechanism according to the invention, a memory is provided, configured for storing at least an indicator relating to the position of the at least one of the first and second clamping member and an indicator relating to the electrical characteristic of the electrical actuator means during the compression of the resilient compression means. These indicators may comprise a direct measurement or e.g. an estimation thereof. By storing said indicators for multiple repeated compressions over time, this collection of stored indicators may be used to determine the need for maintenance, or even to predict the need for a maintenance operation before the system reaches a state wherein maintenance is required to continue operations.

In a second aspect of the present invention, a fluid mixer comprising a housing and an actuator coupled to a clamping mechanism according to the first aspect of the present invention is provided. The fluid mixer may further comprise an agitator for generating a reciprocating force that agitates a clamped container and its contents. Such a fluid mixer is particularly suitable for use as a mixer for paint or varnish contained in cans or other containers. Fluid mixers of this kind have to handle an increasingly broadening assortment of containers, both in material as well as design. Plastic containers replace metal containers, and typical wall thicknesses decrease. Therefore, it is increasingly important to impose the correct amount of pressure during a mixing operation in order to grab the container hard enough to retain and not too hard that the container is damaged or disintegrated.

In an embodiment of the fluid mixer according to the invention, it comprises a controller which is configured to periodically and/or upon a predetermined event and/or upon user request, enable a calibration mode, wherein, in operation, at least one of the first and second clamping member are controlled to the move towards the resilient compression means, such that the resilient compression means are at least partially compressed, while measuring an electrical characteristic of the electrical actuator means and determining at least one of the clamping distance and the amount of compression of the resilient compression means. Such compression means may e.g. be located above the upper clamping member, or under the lower clamping member, but may also be located adjacent or surrounding the guiding and/or actuator means of the clamping members beside of the clamping distance. In operation, a container is placed between the first and second clamping member, while these are positioned at a distance from each other. Before a mixing operation is initialized, the clamping members move towards each other, either by moving one or both of the clamping members towards the other. When the clamping members reach the container, i.e. both have physical contact with the container, the electrical actuator means will move against the stiffness of the container, resulting in a changing electrical characteristic thereof. This may be observed e.g. by an increase of voltage or current to the actuator means. The amount of change in the electrical characteristic or the magnitude thereof, provides an estimation of the applied amount of pressure to the container. By comparing the electrical characteristic with a stored reference value, the amount of pressure applied is estimated. When the estimated value reaches the required pressure, the control means stop the decrease of the clamping distance, e.g. by switching the electrical power to the actuator means, or by not further increasing the power, such that the clamping members substantially maintain the same amount of clamping pressure to the container. In order to calibrate the reference values indicating the relationship between the electrical characteristic and the amount of force imposed by the clamping members, a calibration operation may be executed during the lifetime of the mixer.

In another aspect of the present invention, a method for calibrating a clamping mechanism according to the first aspect of the present invention is provided. The method comprising the steps of actuating at least one of the first and second clamping member to at least partially compress the resilient compression means and further the control means taking a measurement by measuring an electrical characteristic of the electrical actuator means during a compression of the resilient compression means, further comprising the step of comparing the measurement with a predetermined value to calibrate at least a clamping force as a function of the electrical characteristic of the electrical actuator means. At least one of the clamping members is moved against the resilient compression means, while measuring the electrical characteristic of the actuator means, such as e.g. the voltage and/or current to the actuator means. Knowing how much the resilient compression means is compressed, the amount of force between the resilient compression means and the clamping member can be determined. Comparing the amount of force imposed with the electrical characteristic as measured provides an estimation for the relationship between the electrical characteristic and the force imposed. This estimation may be compared with a previously stored reference of this relationship and may be used to update or overwrite the earlier reference, such that a more accurate estimation may be used and the reliability of the system is maintained over its lifespan. In another embodiment of the method according to the invention, the method further comprises the step of determining at least one of an ambient temperature and a temperature of the electrical actuator means, and wherein said temperature is taken into account to calibrate the clamping force as a function of the electrical characteristic of the electrical actuator means. The type of systems in which the method may be applied, operate in various environments with varying temperatures. The ambient temperature may influence the actuator capacity and thereby the calibration of the clamping force, in particular when this ambient temperature varies over time. The same holds for the temperature of the electrical actuator means, which typically rise during continued operation. By taking one or both of these temperatures into account during the calibration of the clamping force, these factors can be equalised, resulting in a better controlled clamping. In particular when the information of the calibration operation is stored in a memory and used for the indication or prediction of a maintenance operation by comparing subsequent calibration operations, the reduced influence of the ambient and actuator temperatures results in even better results.

Further scope of applicability of the present invention will become apparent from the detailed description given hereinafter. However, it should be understood that the detailed description and specific examples, while indicating embodiments of the invention, are given by way of illustration only, since various changes and modifications within the scope of the invention will become apparent to those skilled in the art from this detailed description.

### BRIEF DESCRIPTION OF THE DRAWINGS

The present invention will become more fully understood from the detailed description given hereinbelow and the accompanying schematical drawings which are given by way of illustration only, and thus are not limitative of the present invention, and wherein:
FIG. 1 is a perspective view of a fluid mixer comprising a clamping mechanism according to the present invention;
FIG. 2 is a right front perspective view of the internal shaker frame of the fluid mixer comprising a clamping mechanism of FIG. 1;
FIG. 3 is a front perspective view of the internal shaker frame of the fluid mixer comprising a clamping mechanism of FIGS. 1 and 2;
FIGS. 4a - 4d are a schematic front view of the clamping operation of the fluid mixer of FIGS. 1 - 3;
FIGS. 5a - 5d are a schematic front view of the (re)calibration operation of the fluid mixer of FIGS. 1 - 3;
FIGS. 6a - 6c are a schematic detail of a resilient compression means of the fluid mixer according to the present invention.

### DETAILED DESCRIPTION OF EMBODIMENTS

The present invention will now be described with reference to the accompanying drawings, wherein the same reference numerals have been used to identify the same or similar elements throughout the several views.

It is noted that the drawings are schematic, not necessarily to scale and that details that are not required for understanding the present invention may have been omitted. The terms "upward", "downward", "below", "above", and the like relate to the embodiments as oriented in the drawings, unless otherwise specified. Further, elements that are at least substantially identical or that perform an at least substantially identical function are denoted by the same numeral, where helpful individualised with alphabetic suffixes.

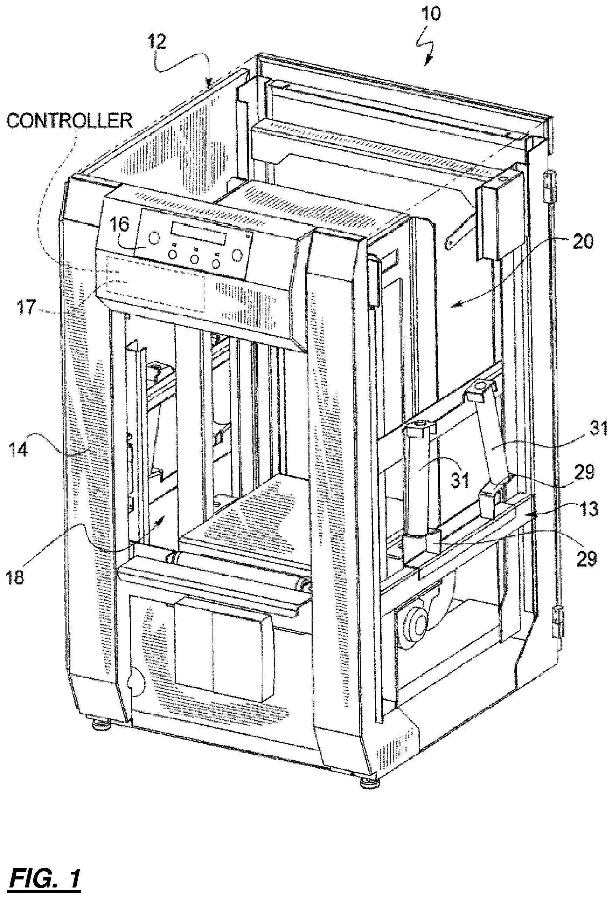

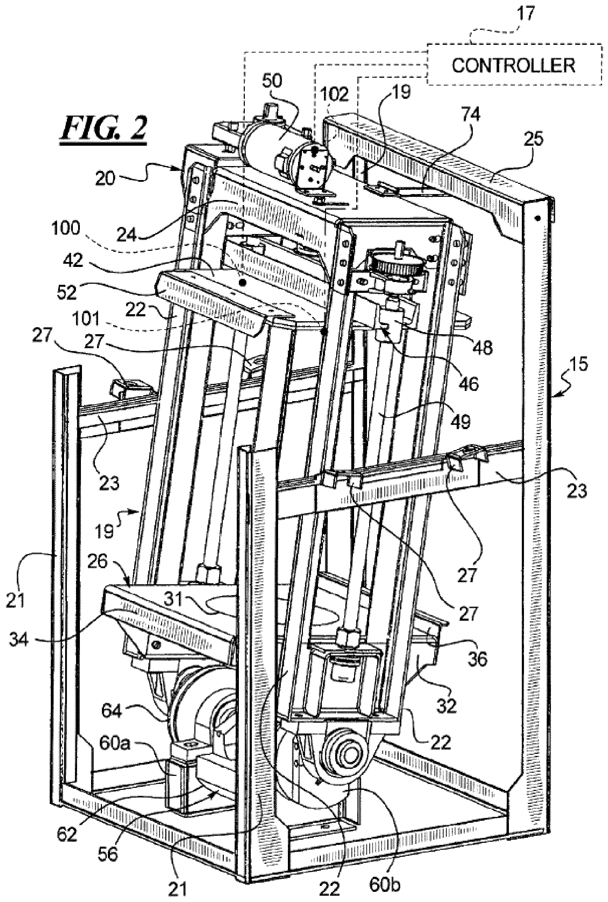

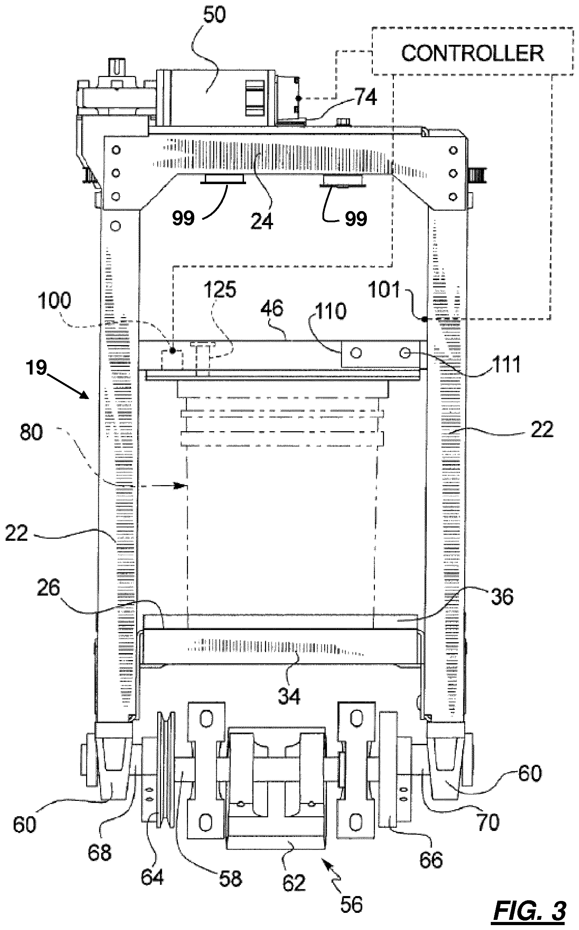

Referring to figure 1, a fluid mixer 10 comprising a clamping mechanism according to the present invention is shown having an outer enclosure 12. The outer enclosure 12 includes a front panel 14 having a controls panel 16 in which input devices may be provided, such as switches and knobs, and output devices, such as a timer and status indicators, for controlling and monitoring operation of the mixer. A controller is shown at 17 for controlling the clamping mechanism 19 shown in FIGS. 2 and 3. The front panel 14 also includes an access window or door 18 through which a user may access an interior of the enclosure 12.
An agitator frame assembly 20 is disposed resiliently mounted via a spring construction in the enclosure 12 for securing a container and for generating a reciprocating force that agitates the container and its contents. The spring construction comprises a plurality of springs 31 which connect the outer enclosure 12 via spring brackets 29 to the spring brackets 27 of the agitator frame assembly 20. As best illustrated in FIG. 2, the agitator frame assembly 20 includes spaced first and second side supports 22, the top ends of which are connected by a cross member 24. The support structure 15 further comprises side supports 21 connected by cross beam 25 and several stiffening elements 23.
A first clamping member is provided as a stationary lower base 26 having a high friction container receptacle and is attached to and extends between bottom portions of the side supports 22. The lower base assembly 26 also includes two side panels 32, a front wall 34, and a rear wall 36 depending therefrom.

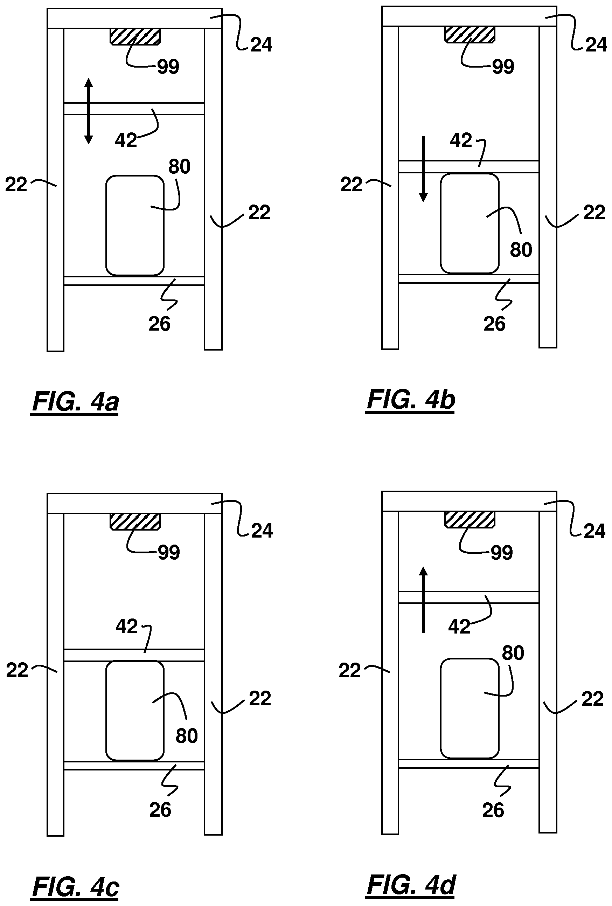

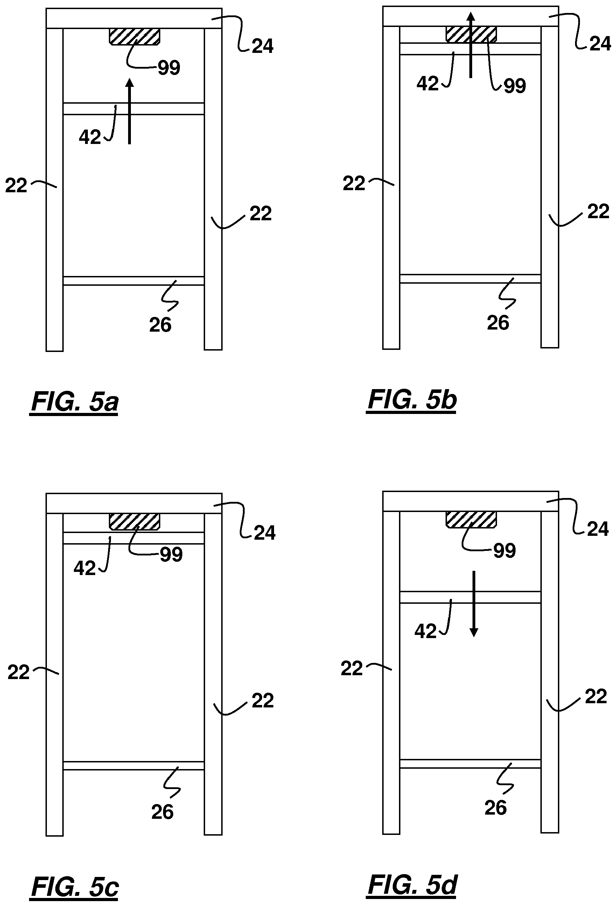

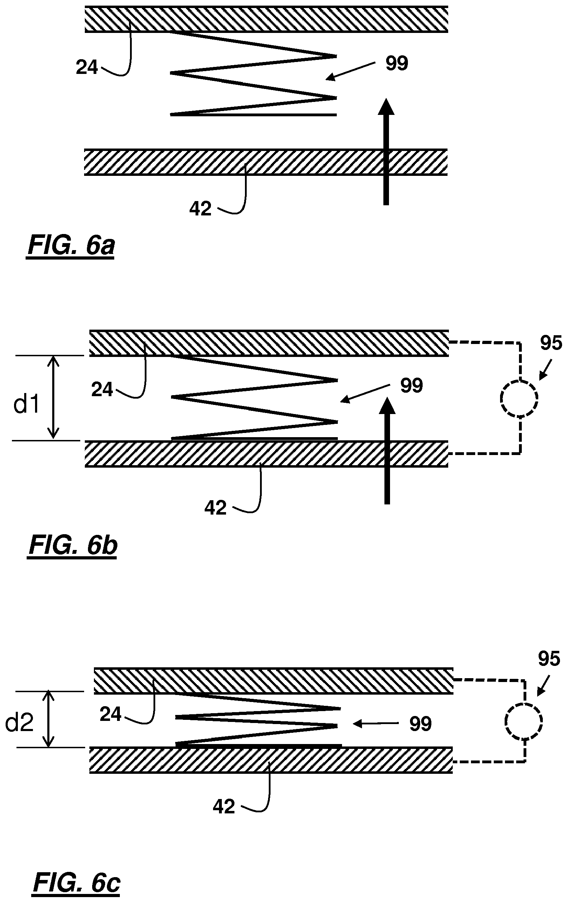

An upper clamping member 42 is disposed above the lower base 26 and is movable in a vertical direction to adjust the spacing between the lower base 26 and upper clamping member 42, i.e. the clamping distance, to thereby accommodate containers of various sizes and to exert the desired clamping force on the container lid. As best shown in FIG. 2, the upper clamping member 42 includes having a generally rectangular shape and a u-shaped cross beam 46 is attached to a top surface of the clamping member 42. A threaded coupling 48 is attached to each end of the u-shaped cross beam 46 and is sized to receive a threaded rod 49. A motor 50 is mounted to the support structure via a bracket 102 and is operably coupled to the threaded rods 49 by way of a pulley mechanism for rotating the rods 49 in either the clockwise or counter-clockwise direction, thereby raising or lowering the upper clamping member 42 with respect to the lower base 26. The upper clamping member 42 may also include a front lip 52 attached to the clamping member 42.
The lower base 26 and upper clamping member 42 form an adjustable clamp for securely holding containers during operation of the mixer 10. A clamping distance is defined between the lower base 26 and upper plate 42. Accordingly, a height of the clamping distance will vary with the position of the upper clamp member 42 with respect to the clamp base 26, thereby allowing the adjustable clamping mechanism to accommodate containers of various heights. In addition, the open frame construction of the agitator frame assembly 20 accommodates various container sizes and shapes.
An eccentric drive 56 is coupled to a bottom of the agitator frame assembly 20 for driving the frame assembly 20 in a reciprocating motion. As illustrated in FIGS. 2 and 3, the eccentric drive 56 includes a drive shaft 58 supported for rotation by two inner bearings 60a and a pair of stub shafts 68, 70 supported by outer bearings 60b. The bearings 60a may be pillow block bearings that are coupled to the stationary outer enclosure 12. A counterweight 62 is coupled to the drive shaft 58. A pulley 64 is attached to one end of the drive shaft 58 adapted to be rotatably driven, such as be a belt coupled to a motor (not shown). A coupling 66 is coupled to the end of the drive shaft 58 opposite the pulley 64. The stub shafts 68, 70 are coupled to the pulley 64 and coupling 66, respectively. The stub shafts 68, 70 are aligned to have substantially the same axis, but are offset from an axis of the drive shaft 58, so that the stub shafts 68, 70 are eccentrically mounted with respect to the drive shaft 58. Outer ends of the stub shafts 68, 70 are rotatably received by the pillow block bearings 60b, coupled to the bottom ends of the side supports 22. As a result, rotation of the drive shaft 58 causes the stub shafts 68, 70 to revolve about an axis of the drive shaft 58, thereby driving the frame assembly 20 in a reciprocating motion. The maximum displacement, or stroke, of the eccentric drive is determined by the distance between the drive shaft axis and the stub shaft axis.
The top of the agitator frame assembly 20 is secured to the outer enclosure 12 by a flexible link. For example, a slat 74 may have a first end attached to the cross member 24 (FIG. 2) and a second end coupled to the enclosure 12. The slat 74 may be flexible to act like a spring, thereby to accommodate movement of the frame assembly 20 during operation of the mixer 10. Accordingly, the bottom end of the frame assembly 20 is secured to the enclosure 12 by the bearings 60 which receive the drive axis 58 and the top end of the frame assembly 20 is secured to the enclosure 12 by the slat 74, thereby maintaining the frame assembly 20 in an upright orientation.
A sensor 100 is disposed or associated with the upper plate 42 and/or cross member 46 for detecting when the upper plate 42 makes contact with a top of a container disposed on the lower base 26. A home sensor 101 is used to keep track of the position of the upper plate 42 and the distance travelled by the upper plate 42 and an optical sensor 125 is mounted to detect the presence of a container between the first and second clamping member. Sensors 100, 101, 125 are linked to the controller 17 or control circuit board.
As shown in FIGS. 3, the upper plate 42 is connected to the cross member 46 by the bracket 110 and fasteners 111. As shown in FIG. 3, the plate 42 and cross member 46 move downward towards the container 80 as controlled by the controller 17. When the plate 42 engages a container 80, i.e. both the base member 26 and the upper clamping member 42 have physical contact with the container 80, the motor 50 will work against the stiffness of the container 80, resulting in a changing electrical characteristic thereof. This may be observed by the controller, e.g. by an increase of voltage or current to the motor 50. The amount of change in the electrical characteristic or the magnitude thereof, provides an estimation of the applied amount of pressure to the container 80. By comparing the electrical characteristic with a stored reference value, the amount of pressure applied is estimated. When the estimated value reaches the required pressure, the controller stops the decrease of the clamping distance, e.g. by switching the electrical power to the motor 50, or by not further increasing the power, such that the clamping members 26, 42 substantially maintain the same amount of clamping pressure to the container 80. In order to calibrate the reference values indicating the relationship between the electrical characteristic and the amount of force imposed by the clamping members 26, 42, a calibration operation may be executed during the lifetime of the mixer 10.
Turning to FIGS 4a - 4d, an exemplary clamping operation is shown in sequence. In Fig 4a, a container 80 is placed on base member 26, which acts as a first clamping member. Base member 26 here is mounted stationary between side supports 22. Second clamping member 42 is mounted moveable within the support structure and in relation to base member 26 and it is actuated by means of actuator means as described hereabove. In an alternative embodiment base member 26 is also mounted moveable within the support structure. After placing the fluid container 80, the clamping member 42 is controllably actuated downward towards base member 26 as shown in Fig 4b. The controller measures the amount of current to the motor 50 while moving the clamping member 42. The moment clamping member 42 reaches the top of the container 80, as shown in Fig. 4b, the current to the actuator means of the clamping member 42 increases. By comparing the increased current with a reference value stored in the controller, the amount of pressure imposed by the clamping member on the container is estimated. When the estimation reaches a predetermined value, e.g. inputted by a user in relation to the specifics of the container, the actuation of the clamping member 42 is stopped, in that the pressure does not further increases as shown in Fig 4c. The container 80 is now well grasped by the clamping members, such that the container is retained in between the first and second clamping member 26, 42, while not crushing the container by excess pressure. The mixing operation is now initialized by engaging the vibrating motion of the eccentric drive 56. In this embodiment, a threaded rod is used as an actuator to move the clamping member 42 up and down, which has a self-braking effect when the power to the motor has stopped. However, in alternative embodiments, the power may be continued after reaching the required pressure in order to inhibit a reversed motion of the clamping member. After mixing the fluid contained in container 80 the vibration is stopped, and the first and second clamping members 26, 42 are moved away from each other, increasing the clamping distance, thereby releasing the grip on the container 80, as shown in Fig 4d.
In order to maintain a good estimation of the relationship between the electric characteristic of the motor 50 and the force or pressure imposed by the clamping members, a (re)calibration procedure may be performed periodically, or at specific events such as start-up and shutdown of the apparatus. This calibration procedure is schematically shown in Figs 5a - 5d. Before initializing the calibration procedure, the controller performs a check to ensure the mixer does not contain a fluid container between the first and second clamping member. In this embodiment, the resilient compression means 99, against which the calibration is performed is mounted above the upper clamping member 42, outside of the clamping distance, i.e. the volume spanned between the base plate 26 and the upper clamping member 42. The upper member 42 is moved toward the resilient compression means 99 as shown in Fig 5a. Upon contact, as shown in fig 5b, the controller signals that the upper clamping member 42 touches the resilient compression means 99, and measures the change of the electrical characteristic to the motor 50, which drives the clamping member 42. Here, the controller measures in particular the current to the motor 50. As the resilient compression means, in casu a helical mechanical spring element 99, increases the load on the actuator of the clamping means, as shown in fig 5c, the current increases. As the controller is aware of the compression of the spring and the relationship between compression and resulting spring force, which is here substantially linear proportional in relation to the compression thereof, the relationship between the increase current to the motor and the force imposed can be determined. The controller compares the relationship between the current to the motor and the force and/or pressure imposed by the clamping member, such that the relationship may be updated or overwritten in case the measured relationship diverges from the reference stored earlier. As shown in fig 5d, the clamping member 42, is subsequently controlled downward to a home position. This procedure may be repeated multiple times, in order to determine a reliable relationship.
In order to distinguish in increase in current to the actuator motor 50 caused by e.g. pollution of the threaded rod, and by compression of the resilient compression means, it is advantageous to determine initial touch of the clamping member with the compression means. Figures 6a - 6c show an embodiment of such a touch sensor. As shown in 6a upper clamping member 42 is moved towards helical spring 99 during a calibration procedure. If the threaded rods, which actuate the clamping member 42 are polluted by e.g. paint or other pollution, the clamping member may be subjected to additional friction. The controller, detects that the clamping member does not touch the compression means yet, and therefore continued driving the upper clamping member 42 further upward, towards the resilient compression means, without starting to determine a relationship between the current to the drive motor 50 and the additional force. Upon touch of the clamping member 42 with the spring 99, as shown in Fig 6b, an electrical circuit 95 toggled, here schematically indicated with the dashed lines 95 which are electronically connected to the controller. Circuit 95 connects the upper clamping member 42 electrically via the spring 99 with the rest of the circuit, thereby closing the electrical loop. The controller signals this toggle and now starts determining the relationship between the current to the motor 50 and the compression of the spring as shown in figure 6c. The controller further compresses the spring during this procedure (d2 < d1) such that the relationship can be determined between the current to the motor and the compression.

Detailed embodiments of the present invention are disclosed herein; however, it is to be understood that the disclosed embodiments are merely exemplary of the invention, which can be embodied in various forms. Therefore, specific structural and functional details disclosed herein are not to be interpreted as limiting, but merely as a basis for the claims and as a representative basis for teaching one skilled in the art to variously employ the present invention in virtually any appropriately detailed structure. In particular, features presented and described in separate dependent claims may be applied in combination and any advantageous combination of such claims are herewith disclosed.

Further, the terms and phrases used herein are not intended to be limiting; but rather, to provide an understandable description of the invention. The terms "a" or "an", as used herein, are defined as one or more than one. The term plurality, as used herein, is defined as two or more than two. A plurality may also indicate a subset of two or more, out of a larger multitude of items. The term another, as used herein, is defined as at least a second or more. The terms including and/or having, as used herein, are defined as comprising (i.e., open language). The term coupled, as used herein, is defined as connected, although not necessarily directly.

Elements and aspects discussed for or in relation with a particular embodiment may be suitably combined with elements and aspects of other embodiments, unless explicitly stated otherwise.

## Claims

1. A mechanism for clamping a container (80), the clamping mechanism (19) comprising a support structure on which a first clamping member (42) and an opposing second clamping member (26) are mounted defining an adjustable clamping distance therebetween, at least one of the first and second clamping member (26, 42) being controllably moveable to increase or decrease the clamping distance by an electrical actuator means (50), which electrical actuator means (50) is controllable by a control means (17), wherein the clamping mechanism further comprises a resilient compression means (99) mounted outside of the clamping distance, **characterized in that** the control means (17) is configured to measure an electrical characteristic of the electrical actuator means during a compression of the resilient compression means (99) by at least one of the first and second clamping member (26, 42) and to compare the measurement with a predetermined value to calibrate at least a clamping force as a function of the electrical characteristic of the electrical actuator means.

2. Clamping mechanism according to claim 1, wherein at least two resilient compression means (99) are mounted outside the clamping distance.

3. Clamping mechanism according to any one of the preceding claims, wherein the resilient compression means (99) is mounted such that an electrical circuit is switched upon initial touch of at least one of the first and second clamping member (26, 42) with the resilient compression means.

4. Clamping mechanism according to any one of the preceding claims, wherein the resilient compression means (99) are configured such that the resulting force of the resilient compression means is substantially proportional with the compression thereof.

5. Clamping mechanism according to any one of the preceding claims, wherein the control means (17) is configured to impose a predetermined clamping force to a container disposed between the first and second clamping member (26, 42).

6. Clamping mechanism according to claim 5, wherein the imposed clamping force is in operation estimated based on at least an electrical characteristic of the electrical actuator (50) means during a change of the clamping distance.

7. Clamping mechanism according to any one of the preceding claims, further comprising detection means for detecting the presence of an object disposed between the first and second clamping member.

8. Clamping mechanism according to any one of the preceding claims, wherein the control means (17) comprise a calibration mode, wherein, in operation, at least one of the first and second clamping member (26, 42) are controlled to the move towards the resilient compression means (99), such that the resilient compression means are at least partially compressed, while measuring an electrical characteristic of the electrical actuator means and determining at least one of the clamping distance and the amount of compression of the resilient compression means.

9. Clamping mechanism according to any one of the preceding claims, wherein the first and second clamping member (26, 42) are substantially planar.

10. Clamping mechanism according to any one of the preceding claims, wherein the electrical characteristic of the electrical actuator means (50) comprises at least one of electrical current and electrical voltage.

11. Clamping mechanism according to any one of the preceding claims, comprising a memory configured for storing at least an indicator relating to the position of the at least one of the first and second clamping member (26, 42) and an indicator relating to the electrical characteristic of the electrical actuator means (50) during the compression of the resilient compression means (99).

12. Fluid mixer (10) comprising a housing and an actuator coupled to a clamping mechanism (19) according to any one of the preceding claims.

13. Fluid mixer (10) according to claim 12, comprising a controller (17) which is configured to periodically and/or upon a predetermined event and/or upon user request, enable a calibration mode, wherein, in operation, at least one of the first and second clamping member (26, 42) are controlled to the move towards the resilient compression means, such that the resilient compression means are at least partially compressed, while measuring an electrical characteristic of the electrical actuator means (50) and determining at least one of the clamping distance and the amount of compression of the resilient compression means (99).

14. Method for calibrating a clamping mechanism according to any one of claims 1 - 11, the method comprising the steps of actuating at least one of the first and second clamping member (26, 42) to at least partially compress the resilient compression means and further the control means (17) taking a measurement by measuring an electrical characteristic of the electrical actuator means (50) during a compression of the resilient compression means, further comprising the step of comparing the measurement with a predetermined value to calibrate at least a clamping force as a function of the electrical characteristic of the electrical actuator means.

15. Method according to claim 14, further comprising the step of determining at least one of an ambient temperature and a temperature of the electrical actuator means (50), and wherein said temperature is taken into account to calibrate the clamping force as a function of the electrical characteristic of the electrical actuator means (50).

## Patentansprüche

1. Mechanismus zum Festklemmen eines Behälters (80), wobei der Klemmmechanismus (19) eine Tragestruktur aufweist, auf der ein erstes Klemmelement (42) und ein gegenüberliegendes zweites Klemmelement (26) montiert sind, die einen einstellbaren Klemmabstand dazwischen definieren, wobei mindestens ein Klemmelement unter dem ersten und dem zweiten Klemmelement (26, 42) durch eine elektrische Aktuatoreinrichtung (50) steuerbar bewegbar ist, um den Klemmabstand zu vergrößern oder zu verkleinern, wobei die elektrische Aktuatoreinrichtung (50) durch eine Steuereinrichtung (17) steuerbar ist, wobei der Klemmmechanismus weiterhin eine elastische Komprimierungseinrichtung (99) aufweist, die außerhalb des Klemmabstands montiert ist,
**dadurch gekennzeichnet, dass**
die Steuereinrichtung (17) dafür konfiguriert ist, eine elektrische Kenngröße der elektrischen Aktuatoreinrichtung während eines Komprimierungsvorgangs der elastischen Komprimierungseinrichtung (99) durch mindestens ein Klemmelement unter dem ersten und dem zweiten Klemmelement (26, 42) zu messen und das Messergebnis mit einem vorgegebenen Wert zu vergleichen, um mindestens eine Klemmkraft als Funktion der elektrischen Kenngröße der elektrischen Aktuatoreinrichtung zu kalibrieren.

2. Klemmmechanismus nach Anspruch 1, bei dem mindestens zwei elastische Komprimierungseinrichtungen (99) außerhalb des Klemmabstands montiert sind.

3. Klemmmechanismus nach einem der vorangehenden Ansprüche, wobei die elastische Komprimierungseinrichtung (99) derart montiert ist, dass bei anfänglicher Berührung mindestens eines Klemmelements unter dem ersten und dem zweiten Klemmelements (26, 42) mit der elastischen Komprimierungseinrichtung ein elektrischer Stromkreis geschlossen wird.

4. Klemmmechanismus nach einem der vorangehenden Ansprüche, wobei die elastische Komprimierungseinrichtung (99) derart konfiguriert ist, dass die resultierende Kraft der elastischen Komprimierungseinrichtung im Wesentlichen proportional zu deren Komprimierung ist.

5. Klemmmechanismus nach einem der vorangehenden Ansprüche, wobei die Steuereinrichtung (17) dafür konfiguriert ist, auf einen Behälter, der zwischen dem ersten und dem zweiten Klemmelement (26) angeordnet ist, eine vorgegebene Klemmkraft auszuüben.

6. Klemmmechanismus nach Anspruch 5, wobei die ausgeübte Klemmkraft im Betrieb basierend auf mindestens einer elektrischen Kenngröße der elektrischen Aktuatoreinrichtung (50) während einer Änderung des Klemmabstands geschätzt wird.

7. Klemmmechanismus nach einem der vorangehenden Ansprüche, die weiterhin eine Erfassungseinrichtung zum Erfassen des Vorhandenseins eines Objekts aufweist, das zwischen dem ersten und dem zweiten Klemmelement angeordnet ist.

8. Klemmmechanismus nach einem der vorhergehenden Ansprüche, wobei die Steuereinrichtung (17) einen Kalibriermodus aufweist, wobei im Betrieb mindestens ein Klemmelement unter dem ersten und dem zweiten Klemmelement (26, 42) gesteuert wird, so dass es sich in Richtung zur elastischen Komprimierungseinrichtung (99) bewegt, so dass die elastische Komprimierungseinrichtung mindestens teilweise komprimiert wird, während eine elektrische Kenngröße der elektrischen Aktuatoreinrichtung gemessen und mindestens ein Parameter unter dem Klemmabstand und dem Komprimierungsmaß der elastischen Komprimierungseinrichtung bestimmt wird.

9. Klemmmechanismus nach einem der vorangehenden Ansprüche, wobei das erste und das zweite Klemmelement (26, 42) im Wesentlichen plan sind.

10. Klemmmechanismus nach einem der vorhergehenden Ansprüche, wobei die elektrische Kenngröße der elektrischen Aktuatoreinrichtung (50) ein elektrischer Strom und/oder eine elektrische Spannung ist.

11. Klemmmechanismus nach einem der vorangehenden Ansprüche, mit einem Speicher, der dafür konfiguriert ist, mindestens eine Anzeige unter einer Anzeige, die mit der Position des mindestens einen Klemmelements unter dem ersten und dem zweiten Klemmelement (26, 42) in Beziehung steht, und einer Anzeige, die mit der elektrischen Kenngröße der elektrischen Aktuatoreinrichtung (50) während der Komprimierung der elastischen Komprimierungseinrichtung (99) in Beziehung steht, zu speichern.

12. Fluidmischer (10) mit einem Gehäuse und einem mit einem Klemmmechanismus (19) nach einem der vorangehenden Ansprüche verbundenen Aktuator.

13. Fluidmischer (10) nach Anspruch 12, mit einer Steuereinheit (17), die dafür konfiguriert ist, periodisch und/oder bei einem vorgegebenen Ereignis und/oder auf Benutzeranforderung einen Kalibrierungsmodus zu aktivieren, wobei im Betrieb mindestens ein Klemmelement unter dem ersten und dem zweiten Klemmelement (26, 42) gesteuert wird, so dass es sich in Richtung zur elastischen Komprimierungseinrichtung bewegt, so dass die elastische Komprimierungseinrichtung mindestens teilweise komprimiert wird, während eine elektrische Kenngröße der elektrischen Aktuatoreinrichtung (50) gemessen und mindestens ein Parameter unter dem Klemmabstand und/oder dem Komprimierungsmaß der elastischen Komprimierungseinrichtung (99) bestimmt wird.

14. Verfahren zum Kalibrieren eines Klemmmechanismus nach einem der Ansprüche 1 bis 11, wobei das Verfahren den Schritt zum Betätigen mindestens eines Klemmelements unter dem ersten und dem zweiten Klemmelement (26, 42) aufweist, um die elastische Komprimierungseinrichtung mindestens teilweise zu komprimieren, wobei ferner die Steuereinrichtung (17) eine Messung durch Messen einer elektrischen Kenngröße der elektrischen Aktuatoreinrichtung (50) während einer Komprimierung der elastischen Komprimierungseinrichtung ausführt, weiterhin mit dem Schritt zum Vergleichen des Messergebnisses mit einem vorgegebenen Wert zum Kalibrieren mindestens einer Klemmkraft als eine Funktion der elektrischen Kenngröße der elektrischen Aktuatoreinrichtung.

15. Verfahren nach Anspruch 14, weiterhin mit dem Schritt zum Bestimmen mindestens eines Parameters unter einer Umgebungstemperatur und einer Temperatur der elektrischen Aktuatoreinrichtung (50), wobei die Temperatur berücksichtigt wird, um die Klemmkraft als eine Funktion der elektrischen Kenngröße der elektrischen Aktuatoreinrichtung (50) zu kalibrieren.

## Revendications

1. Mécanisme pour le serrage d'un contenant (80), le mécanisme de serrage (19) comprenant une structure de support sur laquelle sont montés un premier organe de serrage (42) et un second organe de serrage opposé (26) définissant une distance de serrage ajustable entre eux, au moins l'un des premier et second organes de serrage (26, 42) étant mobile de manière commandable pour augmenter ou réduire la distance de serrage par un moyen d'actionneur électrique (50), lequel moyen d'actionneur électrique (50) est commandable par un moyen de commande (17), dans lequel
le mécanisme de serrage comprend en outre un moyen de compression résilient (99) monté à l'extérieur de la distance de serrage, **caractérisé en ce que** le moyen de commande (17) est configuré pour mesurer une caractéristique électrique du moyen d'actionneur électrique au cours d'une compression du moyen de compression résilient (99) par au moins l'un des premier et second organes de serrage (26, 42) et comparer la mesure d'une valeur prédéterminée pour calibrer au moins une force de serrage en fonction de la caractéristique électrique du moyen d'actionneur électrique.

2. Mécanisme de serrage selon la revendication 1, dans lequel au moins deux moyens de compression résilients (99) sont montés à l'extérieur de la distance de serrage.

3. Mécanisme de serrage selon l'une quelconque des revendications précédentes, dans lequel le moyen de compression résilient (99) est monté de sorte qu'un circuit électrique soit commuté lors d'un contact initial de l'au moins un des premier et second organes de serrage (26, 42) avec le moyen de compression résilient.

4. Mécanisme de serrage selon l'une quelconque des revendications précédentes, dans lequel le moyen de compression résilient (99) est configuré de sorte que la force résultante du moyen de compression résilient est sensiblement proportionnelle à sa compression.

5. Mécanisme de serrage selon l'une quelconque des revendications précédentes, dans lequel le moyen de commande (17) est configuré pour imposer une force de serrage prédéterminée à un contenant disposé entre les premier et second organes de serrage (26, 42).

6. Mécanisme de serrage selon la revendication 5, dans lequel la force de serrage imposée est en fonctionnement estimée sur la base d'au moins une caractéristique électrique du moyen d'actionneur électrique (50) au cours d'un changement de la distance de serrage.

7. Mécanisme de serrage selon l'une quelconque des revendications précédentes, comprenant en outre un moyen de détection pour détecter la présence d'un objet disposé entre les premier et second organes de serrage.

8. Mécanisme de serrage selon l'une quelconque des revendications précédentes, dans lequel le moyen de commande (17) comprend un mode de calibrage, dans lequel, en fonctionnement, au moins l'un des premier et second organes de serrage (26, 42) est commandé pour se déplacer vers le moyen de compression résilient (99), de sorte que le moyen de compression résilient est au moins partiellement comprimé, tout en mesurant une caractéristique électrique du moyen d'actionneur électrique et en déterminant au moins l'une d'une distance de serrage et de la quantité de compression du moyen de compression résilient.

9. Mécanisme de serrage selon l'une quelconque des revendications précédentes, dans lequel les premier et second organes de serrage (26, 42) sont sensiblement plans.

10. Mécanisme de serrage selon l'une quelconque des revendications précédentes, dans lequel la caractéristique électrique du moyen d'actionneur électrique (50) comprend au moins l'un d'un courant électrique et d'une tension électrique.

11. Mécanisme de serrage selon l'une quelconque des revendications précédentes, comprenant une mémoire configurée pour stocker au moins un indicateur lié à la position de l'au moins un des premier et second organes de serrage (26, 42) et un indicateur lié à la caractéristique électrique du moyen d'actionneur électrique (50) au cours de la compression du moyen de compression résilient (99).

12. Mélangeur de fluides (10) comprenant un boîtier et un actionneur couplé à un mécanisme de serrage (19) selon l'une quelconque des revendications précédentes.

13. Mélangeur de fluides (10) selon la revendication 12, comprenant un dispositif de commande (17) qui est configuré pour, périodiquement et/ou lors d'un événement prédéterminé et/ou à la demande de l'utilisateur, activer un mode de calibrage, dans lequel, en fonctionnement, au moins l'un des premier et second organes de serrage (26, 42) est commandé pour se déplacer vers le moyen de compression résilient, de sorte que le moyen de compression résilient est au moins partiellement comprimé, tout en mesurant une caractéristique électrique du moyen d'actionneur électrique (50) et en déterminant au moins l'une de la distance de serrage et de la quantité de compression du moyen de compression résilient (99).

14. Procédé de calibrage d'un mécanisme de serrage selon l'une quelconque des revendications 1 à 11, le procédé comprenant les étapes consistant à actionner au moins l'un des premier et second organes de serrage (26, 42) pour comprimer au moins partiellement le moyen de compression résilient et en outre prendre une mesure par le moyen de commande (17) en mesurant une caractéristique électrique du moyen d'actionneur électrique (50) au cours d'une compression du moyen de compression résilient, comprenant en outre l'étape consistant à comparer la mesure à une valeur prédéterminée pour calibrer au moins une force de serrage en fonction de la caractéristique électrique du moyen d'actionneur électrique.

15. Procédé selon la revendication 14, comprenant en outre l'étape consistant à déterminer au moins l'une d'une température ambiante et d'une température du moyen d'actionneur électrique (50), et dans lequel ladite température est prise en compte pour le calibrage de la force de serrage en fonction de la caractéristique électrique du moyen d'actionneur électrique (50).
